# EUROPEAN PATENT APPLICATION

(11) **EP 2 463 916 A1**
(43) Date of publication of application: **13.06.2012**
(21) Application number: 10806489.0
(22) Date of filing: 04.08.2010
(51) Int. Cl.: H01L 31/04

(54) **STACKED PHOTOVOLTAIC ELEMENT AND METHOD FOR PRODUCING STACKED PHOTOVOLTAIC ELEMENT**

(30) Priority: 05.08.2009 JP 2009182411
(71) Applicant: Sharp Kabushiki Kaisha, Osaka-shi, Osaka 545-8522 (JP)
(72) Inventor: HIGASHIKAWA, Makoto, Osaka 545-852 (JP); SHIMIZU, Takako, Osaka 545-8522 (JP); HONDA, Shinya, Osaka 545-8522 (JP); ISHIKAWA, Yasuaki, Osaka 545-8522 (JP); SANO, Yuichi, Osaka 545-8522 (JP)
(74) Representative: Müller - Hoffmann & Partner
(86) International application number: PCT/JP2010/063200
(87) International publication number: WO 2011/016490

(57) **Abstract**

Disclosed is a stacked photovoltaic element, including: a first photovoltaic element portion (3) including at least one photovoltaic element, stacked over a substrate (1); an intermediate layer (7) made of a metal oxide, stacked over the first photovoltaic element portion (3); a buffer layer (8) in an amorphous state, stacked over the intermediate layer (7); and a second photovoltaic element portion (5) including at least one photovoltaic element, stacked over the buffer layer (8), wherein a conductive layer (5a) of the second photovoltaic element portion (5) in contact with the buffer layer (8) is a microcrystalline layer.

## Description

### TECHNICAL FIELD

The present invention relates to a stacked photovoltaic element, and a method of manufacturing the same.

### BACKGROUND ART

Methods of providing a transparent conductive film between photovoltaic elements in a stacked photovoltaic element formed by stacking a plurality of photovoltaic elements and allowing the transparent conductive film to serve as a reflective layer have been known. For example, Japanese Patent Laying-Open No. 2004-311970 (PTL 1) discloses a configuration in which conductive layers (a p-type layer, an n-type layer) of a photovoltaic element formed over a reflective layer composed of a metal oxide film made of indium oxide, tin oxide, indium tin oxide, zinc oxide, or the like (PTL 1, paragraph [0027]) are microcrystalline layers (PTL 1, paragraph [0033], the last line).

### CITATION LIST

### PATENT LITERATURE

PTL 1: Japanese Patent Laying-Open No. 2004-311970

### SUMMARY OF INVENTION

### TECHNICAL PROBLEM

In a stacked solar cell, with an increase in the crystallization degree of an underlying conductive layer, an i-type layer formed subsequently inherits crystallinity and has a higher crystallization degree. Thus, increasing the crystallization degree of the underlying conductive layer is performed. However, in a case where a conductive layer composed of a microcrystalline layer is formed over a reflective layer, a crystal nuclei are partly formed on a surface at the beginning of film formation, and there are a portion in which a film is formed and a portion in which no film is formed.

Since a microcrystalline layer is generally formed by a plasma CVD method using a high hydrogen-diluted source gas, a portion in which no microcrystalline layer is formed over the reflective layer is exposed to hydrogen plasma for a relatively long time. In particular, when the reflective layer is composed of a metal oxide film, the metal oxide film is reduced and blackened by being exposed to hydrogen plasma. Blackening of the metal oxide film causes a decrease in the amount of transmitted light and an increase in conductivity, and thus there arises a difference in power generation efficiency of a photovoltaic element between a portion exposed to hydrogen plasma for a long time and a portion other than that.

Thus, there is a problem that influence of hydrogen plasma on the underlying metal oxide film given at an initial stage of forming the microcrystalline layer is not uniform in a film surface direction. There is also a problem that, in a portion of the conductive layer in which no microcrystalline layer is formed, due to a difference in film formation conditions from those for the i-type layer formed subsequently, the i-type layer has an insufficient crystallization degree, causing deterioration in conversion efficiency. There is another problem that the i-type layer having an insufficient crystallization degree has white turbidity in appearance, and is delaminated by internal stress when it is left in the atmosphere.

This problem is particularly problematic when a film formation area is increased, that is, when a substrate size is increased.

The present invention has been made in view of the aforementioned problems, and one object of the present invention is to provide a photovoltaic element having improved conversion efficiency.

### SOLUTION TO PROBLEM

A stacked photovoltaic element of the present invention includes: a first photovoltaic element portion including at least one photovoltaic element, stacked over a substrate; an intermediate layer made of a metal oxide, stacked over the first photovoltaic element portion; a buffer layer in an amorphous state, stacked over the intermediate layer; and a second photovoltaic element portion including at least one photovoltaic element, stacked over the buffer layer, **characterized in that** a conductive layer of the second photovoltaic element portion in contact with the buffer layer is a microcrystalline layer.

Preferably, the buffer layer and the microcrystalline layer are layers made of silicon-based semiconductors. In addition, preferably, the intermediate layer is composed of a substantially undoped metal oxide.

Preferably, the buffer layer has a thickness of not more than 10 nm. In addition, preferably, the buffer layer has a conductivity of not less than 5×10⁻³ S/cm and not more than 1×10⁻¹ S/cm.

Preferably, the microcrystalline layer is made of a silicon-based semiconductor having a crystallization degree of not less than 10.

Preferably, the intermediate layer is made of a metal oxide having a conductivity of not less than 2×10⁻¹² S/cm and not more than 1×10⁻⁶ S/cm as a single film. In addition, preferably, the intermediate layer is made of zinc oxide.

The effect of the present invention is exhibited more significantly when the stacked photovoltaic element of the present invention has an integrated structure.

In addition, preferably, in the stacked photovoltaic element of the present invention, the first photovoltaic element portion has at least a pin-type junction, and an i-type layer included in the pin-type junction is composed of an amorphous silicon-based semiconductor.

Preferably, the second photovoltaic element portion has at least a pin-type junction, and an i-type layer included in the pin-type junction is composed of a silicon-based semiconductor containing a crystalline substance.

In addition, preferably, the stacked photovoltaic element of the present invention includes the first photovoltaic element portion and the second photovoltaic element portion in order from a light incident side, the first photovoltaic element portion includes a first pin structural body and a second pin structural body, and an i-type layer included in the first pin structural body is composed of amorphous silicon, or amorphous SiC, or amorphous SiO.

The present invention also relates to a method of manufacturing a stacked photovoltaic element, including the steps of: stacking a first photovoltaic element portion including at least one photovoltaic element over a substrate; stacking an intermediate layer made of a metal oxide over the first photovoltaic element portion; stacking a buffer layer in an amorphous state over the intermediate layer; exposing the buffer layer to hydrogen-containing plasma; and stacking a second photovoltaic element portion including at least one photovoltaic element over the buffer layer, **characterized in that** a conductive layer of the second photovoltaic element portion in contact with the buffer layer is a microcrystalline layer.

### ADVANTAGEOUS EFFECTS OF INVENTION

The stacked photovoltaic element of the present invention includes the intermediate layer and the buffer layer between the first photovoltaic element portion and the second photovoltaic element portion, the buffer layer is in an amorphous state, and the conductive layer of the second photovoltaic element portion in contact with the buffer layer is a microcrystalline layer. Thereby, a reflection function is improved, and conversion efficiency of the entire photovoltaic element can be improved.

### BRIEF DESCRIPTION OF DRAWINGS

Fig. 1 is a cross sectional view showing one example of a structure of a stacked photovoltaic element in present embodiment 1.
Fig. 2A is a cross sectional view showing one example of an integrated structure of the stacked photovoltaic element in present embodiment 1.
Fig. 2B is a cross sectional view showing one example of the integrated structure of the stacked photovoltaic element in present embodiment 1.
Fig. 3A is a schematic cross sectional view of a multi-chamber type plasma CVD apparatus.
Fig. 3B is a schematic cross sectional view showing a configuration of a first film formation chamber in Fig. 3A.
Fig. 4 is a cross sectional view showing one example of a structure of a stacked photovoltaic element in present embodiment 2.

### DESCRIPTION OF EMBODIMENTS

Hereinafter, embodiments of the present invention will be described with reference to the drawings, although the present invention is not limited to the present embodiments. In the description of the embodiments below, parts designated by the same reference numerals in the drawings of the present application indicate identical or corresponding parts.

In the description below, a stacked photovoltaic element having a superstrate-type structure will be described as an example. However, the description below is also applicable to a substrate-type structure. Further, in the present invention, a semiconductor film made of an amorphous semiconductor may be referred to as an "amorphous layer", a semiconductor film made of a microcrystalline semiconductor may be referred to as a "microcrystalline layer", and a film made of an amorphous or microcrystalline semiconductor may be referred to as a "semiconductor layer". In the present invention, "microcrystalline" means a state in which a mixed phase of a crystalline component with a small crystal grain size (about 20 Å to 1000 Å) and an amorphous component is formed.

In addition, in a stacked photovoltaic element, a photovoltaic element located on a light incident side may be referred to as a top cell, and a photovoltaic element located on a side opposite to the light incident side may be referred to as a bottom cell. When another photovoltaic element is provided between the top cell and the bottom cell, the photovoltaic element is referred to as a middle cell.

### <Embodiment 1>

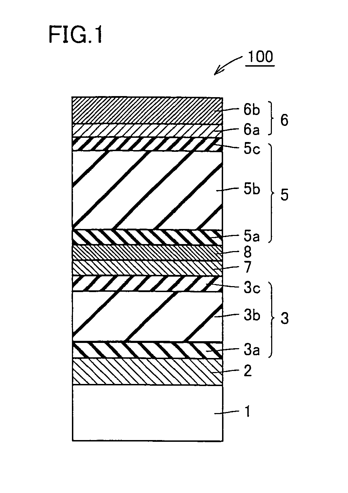

In present embodiment 1, a stacked photovoltaic element including two photovoltaic element portions having a configuration shown in Fig. 1 will be described.

### (Stacked Photovoltaic Element)

Fig. 1 shows a schematic diagram of a cross section of a stacked photovoltaic element in present embodiment 1. As shown in Fig. 1, a stacked photovoltaic element 100 in present embodiment 1 has a stacked structure including a first photovoltaic element portion 3 and a second photovoltaic element portion 5 provided over a substrate 1. In the present invention, an intermediate layer 7 made of a metal oxide is provided between the first photovoltaic element portion 3 and the second photovoltaic element portion 5. In stacked photovoltaic element 100, light is incident from the substrate 1 side.

A first electrode 2 is provided over substrate 1. Substrate 1 and the first electrode 2 are composed of materials having light transmission properties. Specifically, for example, it is preferable that substrate 1 is composed of glass, resin such as polyimide, or the like, and has heat resistance and is usable for a plasma CVD formation process. The first electrode 2 can be composed of SnO₂, indium tin oxide (ITO), or the like. Thicknesses of substrate 1 and the first electrode 2 are not particularly limited, and they have desired shapes. Further, in the present invention, the effect of conversion efficiency of a stacked photovoltaic element using a large-area substrate is fully exhibited, and the effect can be fully seen from a substrate of about 1000 cm² to a large-area substrate of about 100000 cm². The effect of the present invention is also exhibited in a substrate with an area smaller than that.

The first photovoltaic element portion 3 is provided over the first electrode 2, and intermediate layer 7 is provided over an uppermost surface thereof. Then, a buffer layer 8 and the second photovoltaic element portion 5 are provided in this order over intermediate layer 7. Further, as shown in Fig. 1, a second electrode 6 including a transparent conductive film 6a and a metal film 6b is provided on an upper surface of photovoltaic element portion 5. Transparent conductive film 6a is made of, for example, ZnO, and metal film 6b can be formed using, for example, a film made of Ag. Metal film 6b can be arbitrarily provided.

### (First Photovoltaic Element Portion)

The first photovoltaic element portion 3 includes at least one photovoltaic element. It is to be noted that one photovoltaic element has one pin-type junction. The first photovoltaic element portion 3 as described above has a pin-type junction including, for example, a p-type layer 3a made of amorphous hydrogenated silicon (a-Si:H) and an n-type layer 3c made of amorphous hydrogenated silicon provided on both surfaces of an i-type layer 3b made of amorphous hydrogenated silicon. Between p-type layer 3a and i-type layer 3b, for example, an interposed layer such as an i-type amorphous layer composed of amorphous hydrogenated silicon can be arbitrarily provided.

In the first photovoltaic element portion 3, p-type layer 3a is a semiconductor film doped with p-type impurity atoms such as boron, aluminum, or the like. Further, n-type layer 3c is a semiconductor film doped with n-type impurity atoms such as phosphorus.

In addition, a semiconductor film constituting i-type layer 3b may be a completely undoped semiconductor film, or may be a semiconductor film which is of p-type containing a slight amount of impurity or of n-type containing a slight amount of impurity, but is substantially intrinsic and has a photoelectric conversion function sufficiently.

Here, in stacked photovoltaic element 100, i-type layer 3b of the first photovoltaic element portion 3 has a forbidden band width greater than that of an i-type layer 5b of the second photovoltaic element portion 5 described later. By making the forbidden band width of i-type layer 3b of the first photovoltaic element portion 3 greater than the forbidden band width of i-type layer 5b of the second photovoltaic element portion 5, that is, by providing a photovoltaic element having a greater forbidden band width on the incident side, light incident from the substrate 1 side is allowed to contribute to photoelectric conversion over a wide wavelength band.

In the present invention, each semiconductor film constituting the photovoltaic element is not limited to the one illustrated above, and can be any silicon-based semiconductor. For example, it includes an amorphous film or a microcrystalline film of a silicon carbide (SiC)-based compound, a silicon monoxide (SiO)-based compound, or the like, other than a silicon (Si)-based compound as described above. These compounds constituting an amorphous film or a microcrystalline film include a hydrogenated compound, a fluorinated compound, or a hydrogenated and fluorinated compound.

It is to be noted that the first photovoltaic element portion 3 may include silicon-based (Si-based, SiC-based, or SiO-based) semiconductors all of which are of the same type, or may include silicon-based semiconductors which are of types different from each other. Further, each of the p-type, i-type, and n-type semiconductor layers may have a single-layer structure, or a structure in which a plurality of layers are stacked. In the case of the structure in which a plurality of layers are stacked, the layers may be made of silicon-based semiconductors which are of types different from each other.

### (Intermediate layer)

Stacked photovoltaic element 100 has intermediate layer 7 made of a metal oxide over the first photovoltaic element portion 3, that is, on one of both surfaces of the first photovoltaic element portion 3 which is opposite to substrate 1.

For intermediate layer 7, it is suitable to use a material which has a high transmittance and has a large refractive index difference from that of a material used for the first photovoltaic element portion 3, in order to improve efficiency of light absorption by the first photovoltaic element portion 3 through optical reflection at an interface with the first photovoltaic element portion 3.

Intermediate layer 7 is made of a metal oxide. Specifically, one of metal oxides such as indium oxide (In₂O₃), tin oxide (SnO₂), indium tin oxide (ITO), titanium oxide (TiO₂), zinc oxide (ZnO), and the like, or a mixture containing two or more of these metal oxides, or a mixture of at least one of these metal oxides and magnesium oxide (MgO) or the like is suitably used.

Of the above metal oxides, a material containing zinc oxide (ZnO) as a main ingredient is particularly suitable. Using zinc oxide is preferable in that conductive characteristics such as conductivity and sheet resistance can be readily adjusted to desired ranges. The main ingredient described above refers to an ingredient which accounts for 50% or more in atomic ratio of all ingredients constituting the intermediate layer. In particular, intermediate layer 7 containing zinc oxide by 90% or more in atomic ratio is preferable. Further, in these metal oxides, the ratio between oxygen atom concentration and metal atom concentration (i.e., atomic ratio) is preferably not less than 0.960 and not more than 0.975, and more preferably not less than 0.964 and not more than 0.974.

Furthermore, suitably, it is desirable that intermediate layer 7 has a conductivity as a single film satisfying not less than 2×10⁻¹² S/cm and not more than 1×10-6 S/cm. When a single film of intermediate layer 7 has a conductivity as described above, such intermediate layer 7 is preferable in that it can prevent a decrease in electromotive force of stacked photovoltaic element 100 due to an electrical defect.

Here, the conductivity of the intermediate layer as a single film refers to conductivity determined by forming a deposited film deposited over glass under conditions identical to those for forming the intermediate layer, forming parallel electrodes on a surface of the deposited film, measuring a current when a voltage is applied between the parallel electrodes, and plotting them into voltage-current characteristics. Measurement is conducted under atmospheric pressure, at room temperature. Since it is not possible to measure the conductivity of only intermediate layer 7 formed between photovoltaic element portions 3 and 5 in a stacked state as shown in Fig. 1, the conductivity as a single film described above is used.

It has been found that, by setting the conductivity of a metal oxide as a single film to not less than 2×10⁻¹² S/cm and not more than 1×10⁻⁶ S/cm, it is possible to obtain photovoltaic element portion 3 in which a change in conductivity is within an acceptable range, conversion efficiency is high, and a change in conversion efficiency when used is small.

It has also been found that a metal oxide containing a large amount of oxygen and having a low conductivity is desirable, because, even if it is exposed to hydrogen-containing plasma described later, the amount of light transmitting therethrough is not decreased, and deterioration in characteristics of a photovoltaic element is less likely to be caused. This is considered because blackening due to reduction by hydrogen-containing plasma is less likely to occur in such a metal oxide. Specifically, in these metal oxides, the ratio between oxygen atom concentration and metal atom concentration (atomic ratio) is preferably not less than 0.960 and not more than 0.975, and more preferably not less than 0.964 and not more than 0.974.

Preferably, intermediate layer 7 is composed of a substantially undoped metal oxide. Here, a substantially undoped metal oxide refers to a metal oxide in which a dopant component is mixed to an extent where the i-type layer can exhibit the photoelectric conversion function as a so-called intrinsic semiconductor. Preferably, for example, the dopant component is mixed into the metal oxide as a raw material by not more than 0.01 % in atomic ratio, although depending on the type of the metal oxide. Further, intermediate layer 7 is preferably a metal oxide having a hydrogen atom concentration of not less than 2.5×10²⁰ atoms/cm³ and not more than 4.9×10²¹ atoms/cm³. Each atom concentration in the intermediate layer can be determined, for example, by known XPS measurement or SIMS measurement.

Preferably, intermediate layer 7 has a film thickness of not less than 20 nm and not more than 200 nm. Although efficiency of light absorption by the first photovoltaic element portion 3 can also be improved by providing intermediate layer 7 even if the film thickness of intermediate layer 7 is less than 20 nm, when intermediate layer 7 has a film thickness of not less than 20 nm and not more than 200 nm, efficiency of light reflection by intermediate layer 7 is improved, and light reflection efficiency when intermediate layer 7 is used in combination with buffer layer 8 described below is further improved. More preferably, in terms of adhesion property of buffer layer 8, intermediate layer 7 has a film thickness of not less than 50 nm and not more than 150 nm.

### (Buffer Layer)

In stacked photovoltaic element 100, buffer layer 8 is a layer provided between intermediate layer 7 and the second photovoltaic element portion 5 described later, and made of a layer in an amorphous state (also referred to as an amorphous layer). Such buffer layer 8 is preferably a silicon-based semiconductor layer, and particularly desirably an amorphous silicon layer. When buffer layer 8 is a silicon-based semiconductor layer, buffer layer 8 has good adhesion to a surface of intermediate layer 7, and particularly when buffer layer 8 is an amorphous silicon layer, buffer layer 8 has excellent adhesion to a surface of intermediate layer 7.

Preferably, buffer layer 8 has a thickness of not more than 10 nm. It is considered because, when buffer layer 8 has a thickness of not more than 10 nm, it is possible to improve the state of adhesion of a conductive layer of the second photovoltaic element portion 5 formed subsequently over buffer layer 8 to a surface of buffer layer 8. Due to the presence of buffer layer 8, conversion efficiency can be improved, when compared with a stacked photovoltaic element which includes only intermediate layer 7 and does not have buffer layer 8. Therefore, although the lower limit value for the thickness of buffer layer 8 is not particularly limited, the thickness thereof is preferably, for example, not less than 1 nm or not less than 2 nm, in order to cover entire intermediate layer 7 with buffer layer 8 in a stable manner.

Further, the ratio between the thickness of intermediate layer 7 and the thickness of buffer layer 8 (i.e., intermediate layer thickness/buffer layer thickness) is preferably not less than 5 and not more than 200, and more preferably not less than 10 and not more than 150. If such a ratio in thickness is satisfied, the effect of improving a reflection function by providing intermediate layer 7 and buffer layer 8 is further enhanced.

Preferably, buffer layer 8 has a conductivity of not less than 5×10⁻³ S/cm and not more than 5×10⁻¹ S/cm. When buffer layer 8 has a conductivity within the above range, light reflection efficiency is further improved in combination with intermediate layer 7, and conversion efficiency of stacked photovoltaic element 100 is further improved. More preferably, buffer layer 8 has a conductivity of not less than 8×10⁻³ S/cm and not more than 8×10⁻² S/cm. The conductivity of buffer layer 8 can be measured using parallel electrodes, as with the conductivity of intermediate layer 7.

### (Second Photovoltaic Element Portion)

In stacked photovoltaic element 100, the second photovoltaic element portion 5 includes at least one photovoltaic element. Examples of such a photovoltaic element include the one having a pin-type junction.

In the present invention, a conductive layer (a p-type layer 5a in present embodiment 1) of the second photovoltaic element portion in contact with the buffer layer is a microcrystalline layer. When the conductive layer in contact with the buffer layer is a microcrystalline layer as described above, the state of adhesion between surfaces of the buffer layer and the conductive layer is significantly improved. As a result, the effect of improving the reflection function by providing the intermediate layer and the buffer layer becomes more excellent, and conversion efficiency of the stacked photovoltaic element is improved. This is considered because, by forming the microcrystalline conductive layer after depositing the buffer layer, hydrogen appropriately permeates the buffer layer, and thereby a conductive phenomenon occurs in the metal oxide, which allows connection between the photovoltaic element portions to be performed more efficiently.

The second photovoltaic element portion 5 has a configuration having a pin-type junction including, for example, p-type layer 5a made of microcrystalline hydrogenated silicon and an n-type layer 5c made of amorphous hydrogenated silicon provided on both surfaces of i-type layer 5b made of microcrystalline hydrogenated silicon. Between p-type layer 5a and i-type layer 5b, for example, an interposed layer such as an i-type amorphous layer composed of amorphous hydrogenated silicon can be arbitrarily provided.

In the second photovoltaic element portion 5, p-type layer 5a is a semiconductor film doped with p-type impurity atoms such as boron, aluminum, or the like. Further, the n-type layer is a semiconductor film doped with n-type impurity atoms such as phosphorus.

In addition, a semiconductor film constituting i-type layer 5b may be a completely undoped semiconductor film, or may be a semiconductor film which is of p-type containing a slight amount of impurity or of n-type containing a slight amount of impurity, but is substantially intrinsic and has a photoelectric conversion function sufficiently.

As with the first photovoltaic element portion 3, each semiconductor film constituting the second photovoltaic element portion 5 is not limited to the one illustrated above, and can be any silicon-based semiconductor. For example, it includes a film made of a silicon carbide (SiC)-based compound, a silicon monoxide (SiO)-based compound, or the like, other than a silicon (Si)-based compound as described above. The p-type layer is made of a microcrystalline film of these components, and the layers other than the p-type layer include an amorphous film or a microcrystalline film of these components. These compounds constituting an amorphous film or a microcrystalline film include a hydrogenated compound, a fluorinated compound, or a hydrogenated and fluorinated compound.

It is to be noted that the second photovoltaic element portion 5 may include silicon-based (Si-based, SiC-based, or SiO-based) semiconductors all of which are of the same type, or may include silicon-based semiconductors which are of types different from each other. Further, each of the p-type, i-type, and n-type semiconductor layers may have a single-layer structure, or a structure in which a plurality of layers are stacked. In the case of the structure in which a plurality of layers are stacked, the layers may be made of silicon-based semiconductors which are of types different from each other.

Preferably, microcrystalline p-type layer 5a in contact with buffer layer 8 has a crystallization degree of not less than 10. When the crystallization degree is not less than 10, the effect of improving adhesion property described above is further enhanced. In addition, the crystallization degree is preferably not more than 30, because, if the crystallization degree is too high, a microcrystalline structure cannot be maintained. These values of the crystallization degree vary depending on the crystalline state of the silicon-based compound forming the microcrystalline layer.

Here, the crystallization degree is defined as a ratio of a peak height Ic of crystalline silicon of 520 cm⁻¹ attributed to a silicon-silicon bonding to a peak height Ia of amorphous silicon of 480 cm⁻¹, in Raman scattering spectrum of a single conductive layer, that is, Ic/Ia. Although Ic/Ia is not a value representing an absolute value of a crystallized volume fraction, Ic/Ia well reflects the crystallized volume fraction, and thus is a common evaluation value known in the field of the art as an indicator of a ratio of a crystallized component in a film.

### (Integrated Structure)

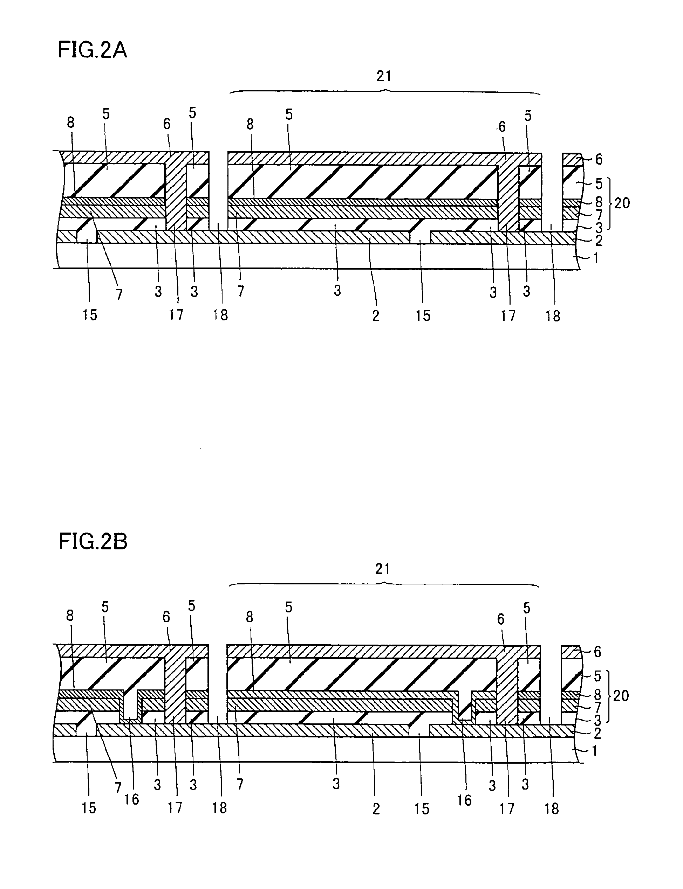

Since the intermediate layer in the present invention further exhibits an effect when there are many leak points, the intermediate layer is suitable for a case where the stacked photovoltaic element has an integrated structure. Figs. 2A and 2B each show one example of an integrated structure of the stacked photovoltaic element in present embodiment 1. That is, an integrated structure refers to a structure including a cell integrated portion 21 as shown in Figs. 2A and 2B, and various forms disclosed in Japanese Patent Laying-Open No. 2008-109041 are illustrated.

As shown in Fig. 2A, the first electrode 2 is separated by a first separation groove 15 filled with the first photovoltaic element portion 3, a photovoltaic element portion 20 is separated by a second separation groove 17, and photovoltaic element portion 20 and the second electrode 6 on a back side are separated by a third separation groove 18. The second separation groove 17 and the third separation groove 18 are contact lines formed by removing photovoltaic element portion 20 using, for example, a laser scribing method.

Further, adjacent photovoltaic elements which are present between the two third separation grooves 18 and separated by the second separation groove 17 are electrically connected in series to constitute cell integrated portion 21. In addition, electrodes for drawing a current (not shown) are respectively formed on a surface of the second electrode 6 faced on the third separation grooves 18 at both ends. When a conductive material having a high conductivity such as Al-doped ZnO is used for intermediate layer 7, an intermediate layer separation groove 16 can be provided to intermediate layer 7 as shown in Fig. 2B.

### (Method of Manufacturing Stacked Photovoltaic Element)

Hereinafter, a method of manufacturing the stacked photovoltaic element in Embodiment 1, that is, stacked photovoltaic element 100 configured as shown in Fig. 1, will be described. Stacked photovoltaic element 100 can be manufactured by forming the first electrode 2, the first photovoltaic element portion 3, intermediate layer 7, buffer layer 8, the second photovoltaic element portion 5, and the second electrode 6, over substrate 1, in order from the light incident side.

### (Step of Forming First Electrode)

Firstly, the first electrode 2 is formed over substrate 1. As described above, substrate 1 is composed of glass, resin such as polyimide, or the like, having light transmission properties, and the first electrode 2 made of a transparent conductive film is formed on one of surfaces of substrate 1 by a known method such as CVD, sputtering, vapor deposition, or the like.

### (Step of Stacking First Photovoltaic Element Portion)

Next, the first photovoltaic element portion 3 is formed over the first electrode 2, for example by the plasma CVD method. Hereinafter, a method of forming the first photovoltaic element portion 3 using a multi-chamber plasma CVD apparatus will be described as an exemplary formation method.

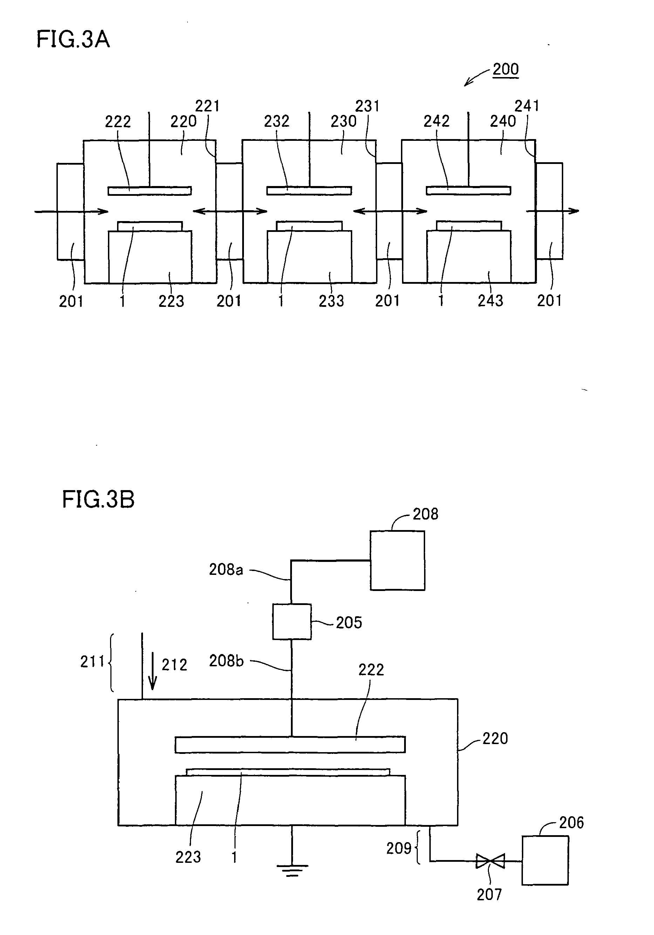

Fig. 3A is a schematic cross sectional view of a multi-chamber type plasma CVD apparatus. A multi-chamber type plasma CVD apparatus 200 shown in Fig. 3A includes three film formation chambers, that is, a first film formation chamber 220, a second film formation chamber 230, and a third film formation chamber 240.

Between the film formation chambers, gate valves 201 for providing communication or blocking between the film formation chambers are provided, and substrate 1 is movable between the film formation chambers through gate valves 201. Each film formation chamber is provided with a pair of electrodes. Specifically, the first film formation chamber 220 is provided with a cathode electrode 222 and an anode electrode 223, the second film formation chamber 230 is provided with a cathode electrode 232 and an anode electrode 233, and the third film formation chamber 240 is provided with a cathode electrode 242 and an anode electrode 243.

A detailed configuration of each film formation chamber will be described with reference to Fig. 3B, taking the first film formation chamber 220 as an example. Fig. 3B is a schematic cross sectional view showing a configuration of the first film formation chamber in Fig. 3A. The second film formation chamber 230 and the third film formation chamber 240 can have a configuration identical to that of the first film formation chamber 220.

As shown in Fig. 3B, the sealable first film formation chamber 220 for forming a semiconductor layer therein includes a gas introducing portion 211 for introducing replacement gas 212 into the first film formation chamber 220, and a gas exhaust portion 206 for exhausting the replacement gas from the first film formation chamber 220. The first film formation chamber 220 can have a size of, for example, about 1 m³.

Inside the first film formation chamber 220, cathode electrode 222 and anode electrode 223 have a parallel plate type electrode structure. The interelectrode distance between cathode electrode 222 and anode electrode 223 is determined in accordance with desired processing conditions, and is generally set to about several millimeters to several tens of millimeters. Outside the first film formation chamber 220, a power supply portion 208 supplying power to cathode electrode 222, and an impedance matching circuit 205 performing impedance matching between cathode electrode 222 and anode electrode 223 are placed.

Power supply portion 208 is connected to one end of a power introducing line 208a. The other end of power introducing line 208a is connected to impedance matching circuit 205. One end of a power introducing line 208b is connected to impedance matching circuit 205, and the other end of power introducing line 208b is connected to cathode electrode 222. As power supply portion 208, the one capable of outputting a pulse-modulated (on/off controlled) alternating current (AC), or the one capable of outputting CW (continuous waveform) alternating current by switching is used.

Anode electrode 223 is electrically grounded, and substrate 1 is placed on anode electrode 223. Substrate 1 is arranged, for example, with the first electrode 2 being formed thereon. Although substrate 1 may be placed on cathode electrode 222, it is generally placed on anode electrode 223 to decrease deterioration in film quality due to ion damage in plasma.

The first film formation chamber 220 is also provided with gas introducing portion 211. Gas 212 such as a dilution gas, a source gas, and a doping gas is introduced from gas introducing portion 211. Examples of the dilution gas include a gas containing hydrogen gas, and examples of the source gas include a silane-based gas, methane gas, germane gas, and the like. Examples of the doping gas include a p-type impurity doping gas such as diborane gas, and an n-type impurity doping gas such as phosphine gas.

Gas exhaust portion 206 and a valve 207 for adjusting pressure are connected in series to the first film formation chamber 220, and gas pressure inside the first film formation chamber 220 is maintained substantially constant. Since the gas pressure has a slight error if it is measured in the vicinity of gas introducing portion 211 and a gas exhaust port 209 inside the film formation chamber, it is desirable to measure the gas pressure at a position away from gas introducing portion 211 and gas exhaust port 209. By supplying power to cathode electrode 222 in this state, plasma is generated between cathode electrode 222 and anode electrode 223. The plasma decomposes gas 212 introduced into the first film formation chamber 220, and thereby a semiconductor layer can be formed over substrate 1.

As gas exhaust portion 206, the one capable of exhausting gas such that the gas pressure inside the first film formation chamber 220 obtains a high vacuum of about 1.0×10⁻⁴ Pa can be employed. Examples of gas exhaust portion 206 include a rotary pump, a mechanical booster pump, a sorption pump, a turbo-molecular pump, and the like, and it is preferable to use one of them singularly, or a combination of two or more pumps. As typical gas exhaust portion 206, a mechanical booster pump and a rotary pump connected in series can be used.

The configurations shown in Figs. 3A and 3B are exemplary, and a semiconductor layer may be formed using an apparatus having another configuration. The step of forming a semiconductor layer by a method other than plasma CVD may be included.

Here, a method of forming the first photovoltaic element portion 3 using plasma CVD apparatus 200 having the above configuration will be described.

Firstly, p-type layer 3a made of amorphous hydrogenated silicon is formed in the first film formation chamber 220. Specifically, the first film formation chamber 220 is evacuated to 0.001 Pa, and the temperature of substrate 1 provided with the first electrode 2 placed on anode electrode 223 is set to not more than 200°C. Next, a mixed gas is introduced into the first film formation chamber 220, and the pressure inside the first film formation chamber 220 is maintained substantially constant, for example at not less than 200 Pa and not more than 3000 Pa, by valve 207 provided to an exhaust system.

As the mixed gas to be introduced into the first film formation chamber 220, for example, a mixed gas containing silane gas, hydrogen gas, and diborane gas can be used. In order to further decrease the amount of light absorption, a gas containing carbon atoms (for example, methane gas) may be contained in the above mixed gas. In this case, a SiC-based semiconductor can be formed. Desirably, in the above mixed gas, the hydrogen gas has a flow rate about several times (twice to three times) to several tens of times (20 to 30 times) that of the silane gas.

After the above mixed gas is introduced and the pressure inside the first film formation chamber 220 is stabilized, an AC power of several kHz to 80 MHz is input to cathode electrode 222 to generate plasma between cathode electrode 222 and anode electrode 223. P-type layer 3a is formed by this plasma. Power density per unit area of cathode electrode 222 is set to, for example, not less than 0.01 W/cm² and not more than 0.3 W/cm². Such power density can be adjusted by a known method, in terms of film formation characteristics and film formation rate.

The above power density is maintained, and power input is stopped when p-type layer 3a has a desired thickness. Thereafter, the first film formation chamber 220 is evacuated to vacuum. The thickness of p-type layer 3a can be increased in proportion to a total amount of input power (power density × time). From the viewpoint of providing a sufficient internal electric field to i-type layer 3b, the thickness of p-type layer 3a is preferably not less than 2 nm, and more preferably not less than 5 nm. Further, from the viewpoint that suppressing the amount of light absorption by an inactive layer on the incident side is required, the thickness of p-type layer 3a is preferably not more than 50 nm, and more preferably not more than 30 nm.

When the first photovoltaic element portion 3 includes an interposed layer, the interposed layer is formed subsequent to p-type layer 3a in the first film formation chamber 220. The interposed layer can be formed by a method identical to the method of forming p-type layer 3a described above, except that a mixed gas of silane gas and hydrogen gas, or a gas prepared by further mixing a gas containing hydrocarbon such as methane gas into the mixed gas is used as a mixed gas to be introduced into the first film formation chamber 220.

When the interposed layer is provided, although its thickness is not particularly limited, it desirably has a thickness of not less than 2 nm to suppress diffusion of a p-type impurity such as boron atoms from p-type layer 3a to i-type layer 3b. On the other hand, the interposed layer is desirably as thin as possible to suppress the amount of light absorption and increase light reaching i-type layer 3b, and thus the thickness of the interposed layer is generally set to not more than 50 nm.

By forming an i-type amorphous layer as the interposed layer, the concentration of impurity atoms such as boron in the atmosphere inside the first film formation chamber 220 is decreased, and mixing of the impurity atoms into i-type layer 3b to be formed subsequently can be decreased.

Next, i-type layer 3b made of amorphous hydrogenated silicon (a-Si:H) is formed. I-type layer 3b is formed, for example, in the second film formation chamber 230. Therefore, substrate 1 having p-type layer 3a or p-type layer 3a and the interposed layer formed thereover is transported from the first film formation chamber 230, via gate valve 201, to the second film formation chamber 230.

I-type layer 3b can be formed by a method identical to the method of forming p-type layer 3a described above, except that a different film formation chamber is used, and that a mixed gas containing, for example, silane gas and hydrogen gas is used as a mixed gas to be introduced into film formation chamber 230. When i-type layer 3b is formed, the hydrogen gas in the above mixed gas preferably has a flow rate about several times to several tens of times, for example, not less than five times and not more than 30 times, that of the silane gas. By satisfying such relationship in flow rate, i-type layer 3b having good film quality can be formed.

Preferably, i-type layer 3b has a thickness from 0.05 µm to 0.25 µm, considering the amount of light absorption and deterioration in photoelectric conversion characteristics due to light degradation.

Next, n-type layer 3c made of amorphous hydrogenated silicon (a-Si:H) is formed. N-type layer 3c is formed, for example, in the third film formation chamber 240. Therefore, substrate 1 having i-type layer 3b formed thereover is transported from the second film formation chamber 240, via gate valve 201, to the third film formation chamber 250.

N-type layer 3c can be formed by a method identical to the method of forming p-type layer 3a described above, except that a different film formation chamber is used, and that a mixed gas containing, for example, silane gas, hydrogen gas, and phosphine gas is used as a mixed gas to be introduced into film formation chamber 240. When n-type layer 3c is formed, the hydrogen gas in the above mixed gas has a flow rate which is preferably not less than five times and not more than 300 times, and preferably not less than 30 times and not more than 300 times, that of the silane gas.

In order to provide a sufficient internal electric field to i-type layer 3b, n-type layer 3c preferably has a thickness of not less than 2 nm. On the other hand, in order to suppress the amount of light absorption by n-type layer 3c as an inactive layer, n-type layer 3c is preferably as thin as possible, and the thickness thereof is generally set to not more than 50 nm.

Through the steps described above, the first photovoltaic element portion 3 including i-type layer 3b as a photoelectric conversion layer can be formed.

### (Step of Stacking Intermediate layer)

The step of stacking intermediate layer 7 can be performed, for example, by arranging the substrate having the first photovoltaic element portion 3 formed thereover in a known sputtering apparatus, introducing a mixed gas of argon gas and oxygen gas, and conducting a sputtering method using a target containing a substantially undoped metal oxide as a main ingredient. Preferably, a flow ratio O₂/Ar between the oxygen gas and the argon gas is set to not less than 1% and not more than 8%. When the flow ratio between the oxygen gas and the argon gas is within the above range, conductivity and sheet resistance of intermediate layer 7 can be easily set within the ranges of the present invention.

As the target, for example, a single metal oxide such as zinc oxide may be used, or a target containing a metal oxide such as zinc oxide by 80% or more of its constituent atoms, and containing magnesium, calcium, and the like by the remaining percent may be used.

As for conditions for sputtering, as long as the flow ratio described above is satisfied, other conditions such as temperature, pressure, and power density can be changed as appropriate in accordance with the film formation rate. For example, it is desirable to set conditions that the temperature is not less than 70°C and not more than 150°C, the pressure is not less than 0.05 Pa and not more than 0.75 Pa, and the power density is not less than 1 W/cm² and not more than 5 W/cm². Further, the thickness of intermediate layer 7 can be adjusted by a time period to apply a current.

### (Step of Stacking Buffer Layer)

The step of forming the buffer layer can be performed by a method identical to the method of forming i-type layer 3b in the first photovoltaic element portion 3, except that a hydrogen dilution ratio and power density are adjusted to make buffer layer 8 amorphous. For example, the buffer layer can be formed under formation conditions described below. It is desirable to arrange substrate 1 provided with the first photovoltaic element portion 3 and intermediate layer 7 in a film formation chamber of plasma CVD apparatus 200, and set the temperature of the substrate to not more than 200°C. The pressure inside the film formation chamber during formation is desirably not less than 240 Pa and not more than 3600 Pa. Further, power density per unit area of a cathode electrode is desirably set to not less than 0.01 W/cm² and not more than 0.2 W/cm².

The hydrogen gas has a flow rate which is desirably about several times to several hundred times, and more desirably about 10 times to 100 times, that of the silane gas. Thus, buffer layer 8 made of hydrogenated silicon in an amorphous state can be formed.

### (Step of Exposing Buffer Layer to Hydrogen-Containing Plasma)

The method of manufacturing the stacked photovoltaic element of the present invention includes the step of exposing buffer layer 8 to hydrogen-containing plasma. This step is a step of exposing the buffer layer to hydrogen-containing plasma under conditions in which no layer is formed, and adjusting conductive characteristics of intermediate layer 7 underlying the buffer layer. This step can also be performed in the step of forming the conductive layer of the second photovoltaic element portion 5.

As a result of earnest study by the inventors of the present invention, it has been found that, by exposing a buffer layer on a metal oxide film to hydrogen-containing plasma, hydrogen radicals contained in the hydrogen-containing plasma permeate the film made of a metal oxide such as zinc oxide (ZnO) via the buffer layer, and decrease the resistance of the metal oxide. It has also been found that conditions for exposure to the hydrogen radicals are important. It is to be noted that this step can also be performed using the plasma CVD apparatus in Fig. 3A.

This step can be performed, for example, using a mixed gas of hydrogen gas and an impurity doping gas, which is equal to a film formation gas for forming p-type layer 5a to be formed subsequently with silane gas being excluded therefrom.

It is preferable to perform hydrogen-containing plasma processing before conductive layer 5a is stacked over buffer layer 8. The processing of exposing the buffer layer to hydrogen-containing plasma (plasma processing) may also serve as the step of forming conductive layer 5a. Preferably, conditions in a case where the hydrogen-containing plasma processing also serves as the step of forming conductive layer 5a as described above are also adjusted such that intermediate layer 7 satisfies the ranges of conductive characteristics described above.

As a specific method for the step of exposing buffer layer 8 to hydrogen-containing plasma, for example, substrate 1 having intermediate layer 7 formed thereover is arranged in a film formation chamber of the plasma CVD apparatus, the pressure inside the film formation chamber is adjusted to not less than 240 Pa and not more than 3600 Pa, and a gas serving as a source for hydrogen-containing plasma is introduced. As the gas serving as a source for hydrogen-containing plasma, a mixed gas containing hydrogen gas, and SiH₄, CH₄, CO₂, or the like, and a gas of a dopant component such as B₂H₆, PH₃, or the like can be used. Plasma can be generated by applying a power of 0.01 W/cm² to 0.5 W/cm² to the mixed gas.

If time for which buffer layer 8 is exposed to hydrogen-containing plasma is increased, intermediate layer 7 tends to have an increased conductivity, and if the pressure inside the film formation chamber is increased, time taken to achieve a certain conductivity tends to be shortened. These conditions are changed depending on the size of substrate 1 and the thicknesses of buffer layer 8 and intermediate layer 7. Processing efficiency can be improved by increasing reaction time or increasing the pressure inside the film formation chamber with an increase in the size of substrate 1 or in the thicknesses of buffer layer 8 and intermediate layer 7.

### (Step of Stacking Second Photovoltaic Element Portion)

The step of stacking the second photovoltaic element portion including at least one photovoltaic element can be performed in the same way as the method of forming the first photovoltaic element portion described above. It is to be noted that, in order to make the forbidden band width of i-type layer 5b of the second photovoltaic element portion 5 smaller than the forbidden band width of i-type layer 3b of the first photovoltaic element portion, the second photovoltaic element portion 5 is preferably formed under conditions described below.

The second photovoltaic element portion 5 can be, for example, a photovoltaic element including a pin structure composed of p-type layer 5a, i-type layer 5b, and n-type layer 5c which are all made of microcrystalline layers. In addition, the second photovoltaic element portion 5 includes a manner provided with an interposed layer between p-type layer 5a and i-type layer 5b, a manner in which i-type layer 5b is amorphous, and the like.

P-type layer 5a made of a microcrystalline layer to be formed over buffer layer 8 can be formed, for example, under formation conditions described below. It is desirable to arrange substrate 1 provided with the first photovoltaic element portion 3, intermediate layer 7, and buffer layer 8 in a film formation chamber of plasma CVD apparatus 200, and set the temperature of the substrate to not more than 200°C. The pressure inside the film formation chamber during formation is desirably not less than 240 Pa and not more than 3600 Pa. Further, power density per unit area of a cathode electrode is desirably set to not less than 0.01 W/cm² and not more than 0.5 W/cm².

As a mixed gas to be introduced into the film formation chamber, for example, a gas containing silane gas, hydrogen gas, and diborane gas can be used. The hydrogen gas has a flow rate which is desirably about 100 times to 400 times, and more desirably not less than 200 times and not more than 400 times, that of the silane gas. When p-type layer 5a is formed under such conditions, intermediate layer 8 is exposed to hydrogen-containing plasma and hydrogen is diffused into p-type layer 5a, and thereby p-type layer 5a becomes a film having an appropriate resistance. The resistance of p-type layer 5a serves as an appropriate resistance to a direction of the surface of intermediate layer 8, and thus intermediate layer 8 having a small series resistance at a joint interface with the photovoltaic element portion can be formed. In this manner, microcrystalline p-type layer 5a having a crystallization degree of, for example, not less than 10 can be formed.

In order to provide a sufficient internal electric field to i-type layer 5b, p-type layer 5a preferably has a thickness of not less than 2 nm. On the other hand, in order to suppress the amount of light absorption by p-type layer 5a as an inactive layer and increase light reaching i-type layer 5b, the thickness of p-type layer 5a is desirably as thin as possible, and is generally set to not more than 50 nm. Further, from the viewpoint of improving adhesion property to the buffer layer, the thickness of p-type layer 5a is preferably set to not less than 5 nm and not more than 40 nm.

Next, i-type layer 5b is formed. I-type layer 5b can be formed, for example, under formation conditions described below. The temperature of the substrate is desirably set to not more than 200°C. The pressure inside a film formation chamber during formation is desirably not less than 240 Pa and not more than 3600 Pa. Further, power density per unit area of a cathode electrode is desirably set to not less than 0.02 W/cm² and not more than 0.5 W/cm².

As a mixed gas to be introduced into the film formation chamber, for example, a gas containing silane gas and hydrogen gas can be used. The hydrogen gas has a flow rate which is desirably about 30 times to several hundred times, and more desirably about 30 times to 300 times, that of the silane gas.

In order to ensure a sufficient amount of light absorption, i-type layer 5b has a thickness preferably of not less than 0.5 µm, more preferably of not less than 1 µm.

On the other hand, in order to ensure good productivity, i-type layer 5b has a thickness preferably of not more than 20 µm, more preferably of not more than 15 µm.

Next, n-type layer 5c is formed. N-type layer 5c can be formed, for example, under formation conditions described below. The temperature of the substrate is desirably set to not more than 200°C. The pressure inside a film formation chamber during formation is desirably not less than 240 Pa and not more than 3600 Pa. Further, power density per unit area of a cathode electrode is desirably set to not less than 0.02 W/cm² and not more than 0.5 W/cm².

As a mixed gas to be introduced into the film formation chamber, for example, a gas containing silane gas, hydrogen gas, and phosphine gas can be used. The hydrogen gas has a flow rate which is desirably about several tens of times to several hundred times, and more desirably about 30 times to 300 times, that of the silane gas.

In order to provide a sufficient internal electric field to i-type layer 5b, n-type layer 5c preferably has a thickness of not less than 2 nm. On the other hand, in order to suppress the amount of light absorption by n-type layer 5c as an inactive layer, the thickness of n-type layer 5c is preferably as thin as possible, and is generally set to not more than 50 nm. However, the thickness of n-type layer 5c is not limited to this range.

### (Step of Forming Second Electrode)

Next, the second electrode 6 is formed over the second photovoltaic element portion 5. The second electrode 6 includes transparent conductive film 6a and metal film 6b, which can be formed in order. Transparent conductive film 6a can be formed using a film made of SnO₂, ITO, ZnO, or the like. Metal film 6b can be formed using a film made of a metal such as Ag, aluminum, or the like. Transparent conductive film 6a and metal film 6b are formed by a method such as CVD, sputtering, vapor deposition, or the like. Metal film 6b can also be omitted.

As described above, stacked photovoltaic element 100 of present embodiment 1 is manufactured. Since stacked photovoltaic element 100 manufactured as described above includes specific intermediate layer 7 and buffer layer 8, it can have improved conversion efficiency.

Although the above description illustrates a case where the semiconductor layers are formed using a multi-chamber type plasma CVD apparatus having a plurality of film formation chambers as shown in Fig. 3A, they can also be formed using a single-chamber plasma CVD apparatus. In this case, since the p-type, i-type, and n-type semiconductor layers are formed in one film formation chamber, it is preferable to provide a known gas replacement step between the respective steps.

In a case where a multi-chamber type plasma CVD apparatus is used, the apparatus is not limited to the form as described above, and may have a manner such that a p-type layer and an interposed layer are formed in different film formation chambers using an apparatus having four or more film formation chambers.

### <Embodiment 2>

Present embodiment 2 relates to a stacked photovoltaic element in which a first photovoltaic element portion includes two photovoltaic elements. Except that the first photovoltaic element portion includes two photovoltaic elements, the stacked photovoltaic element in embodiment 2 has a structure identical to that in embodiment 1 described above.

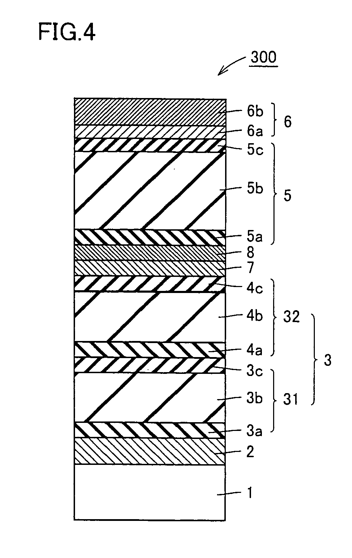

Fig. 4 is a cross sectional view showing one example of a structure of the stacked photovoltaic element in present embodiment 2. In Fig. 4, a stacked photovoltaic element 300 includes substrate 1, the first electrode 2, the first photovoltaic element portion 3 in which a first pin structural body 31 and a second pin structural body 32 are stacked, intermediate layer 7, buffer layer 8, the second photovoltaic element portion 5 having one pin structural body, and the second electrode 6, in order from the light incident side. In stacked photovoltaic element 300, the first pin structural body 31 in the first photovoltaic element portion 3 can have a configuration identical to that of the first photovoltaic element portion 3 in embodiment 1, and the second photovoltaic element portion 5 can have a configuration identical to that in embodiment 1.

Hereinafter, a method of manufacturing the first photovoltaic element portion 3 in stacked photovoltaic element 300 with a configuration shown in Fig. 4 will be described. Since methods of manufacturing other components are identical to those in embodiment 1, the description thereof will not be repeated.

### (Step of Stacking First Photovoltaic Element Portion)

The first photovoltaic element portion 3 is formed over the first electrode 2 formed over substrate 1. The first photovoltaic element portion 3 has the first pin structural body 31 including p-type layer 3a, i-type layer 3b, and n-type layer 3c. and the second pin structural body 32 including a p-type layer 4a, an i-type layer 4b, and a n-type layer 4c. The semiconductor layers are formed in order as described below.

Firstly, a photovoltaic element including the first pin structural body 31 is stacked over the first electrode 2. The first pin structural body 31 including p-type layer 3a, i-type layer 3b, and n-type layer 3c is formed by a method identical to the method of manufacturing the first photovoltaic element portion 3 in embodiment 1 described above.

Next, a photovoltaic element including the second pin structural body 32 in the first photovoltaic element portion 3 is stacked. I-type layer 4b in the photovoltaic element can be composed of amorphous hydrogenated silicon (a-Si:H) such that its forbidden band width is smaller than the forbidden band width of i-type layer 3b, and the p-type layer and the n-type layer other than that can be formed by formation methods identical to those in the first pin structural body 31. Thicknesses and formation conditions of the semiconductor layers other than i-type layer 4b may be identical to or different from those in the first pin structural body 31.

Firstly, p-type layer 4a is formed by a method identical to the method of forming p-type layer 3a in the first pin structural body 31.

Next, i-type layer 4b made of amorphous hydrogenated silicon is formed. Preferably, the thickness of i-type layer 4b is set to a value from 50 nm to 500 nm, considering the amount of light absorption and deterioration in photoelectric conversion characteristics due to light degradation. Further, it is desirable that i-type layer 4b in the second pin structural body 32 has a forbidden band width smaller than the forbidden band width of i-type layer 3b in the first pin structural body 31, because, with such a forbidden band width, light in a wavelength band which cannot be absorbed by a photoelectric conversion layer on the substrate side can be absorbed by a photoelectric conversion layer in the second pin structural body 32, and thus incident light can be effectively utilized.

In order to make the forbidden band width of i-type layer 4b smaller than the forbidden band width of i-type layer 3b in the first pin structural body 31. i-type layer 4b is manufactured, for example, under conditions described below.

Firstly, a film formation chamber is evacuated to a background pressure of about 0.001 Pa, and the temperature of substrate 1 is set to not less than 150°C and not more than 250°C. Next, a mixed gas is introduced into the film formation chamber, and the pressure inside the film formation chamber is maintained substantially constant by a pressure adjustment valve. The pressure inside the film formation chamber is set to, for example, not less than 10 Pa and not more than 3000 Pa. As the mixed gas to be introduced into the film formation chamber, for example, a gas containing silane gas and hydrogen gas can be used. The hydrogen gas has a flow rate which is desirably equal to or more than that of the silane gas, and is more preferably not less than five times and not more than 30 times that of the silane gas (H₂/SiH₄).

After the pressure inside the film formation chamber is stabilized, for example, an AC power having a frequency of 13.56 MHz is input to a cathode electrode to generate plasma between the cathode electrode and an anode electrode and form i-type layer 3b. Power density per unit area of the cathode electrode can be set to not less than 0.01 W/cm² and not more than 0.3 W/cm². As the frequency described above, a frequency from several kHz to a frequency in the VHF band, and further a frequency in the microwave band may be used.

After i-type layer 4b with a desired thickness is formed as described above, input of the AC power is stopped, and thereafter the film formation chamber is evacuated to vacuum.

Subsequently, n-type layer 4c is formed by a method identical to the method of forming n-type layer 3c in the first pin structural body 31. Thus, the first photovoltaic element portion in which the second pin structural body 32 is stacked over the first pin structural body 31 is formed.

It is to be noted that the forbidden band width of i-type layer 3b in the first pin structural body 31 may be equal to or smaller than the forbidden band width of i-type layer 4b in the second pin structural body 32. Also in this case, i-type layer 4b in the second pin structural body 32 contributes to absorption of light which fails to be absorbed by i-type layer 3b in the first pin structural body 31.

Further, generally, as the i-type layer has an increased thickness, light degradation of the i-type layer has more influence on photoelectric conversion efficiency, decreasing the photoelectric conversion efficiency more significantly even if light degradation characteristics per unit film thickness of the i-type layer is identical. Regarding this, according to present embodiment 2, two photovoltaic elements each having an i-type layer are formed, and thereby each i-type layer included in the first photovoltaic element portion can have a relatively thin thickness. This can suppress the influence of degradation of the i-type layer included in the first photovoltaic element portion, on the photoelectric conversion efficiency.

In addition, in the first pin structural body 31 or the second pin structural body 32, an interposed layer may be provided between the p-type layer and the i-type layer, and such an interposed layer can be formed as in embodiment 1 described above.

Since stacked photovoltaic element 300 in present embodiment 2 includes specific intermediate layer 7 and buffer layer 8, it has an improved reflection function when compared with a conventional element, and conversion efficiency of the entire element is improved.

### Examples

Hereinafter, the present invention will be described in more detail with reference to examples. However, the present invention is not limited thereto.

### (Examples 1 to 4)

In the present examples, a pin-type photovoltaic element including an i-type layer made of intrinsic amorphous hydrogenated silicon (Si:H) was formed as a first photovoltaic element portion, a pin-type photovoltaic element including an i-type layer made of intrinsic microcrystalline Si:H was formed as a second photovoltaic element portion, and a layer made of zinc oxide (ZnO) containing an Al dopant by not more than 3% was formed as an intermediate layer, to fabricate a stacked photovoltaic element as shown in Fig. 1. A specific description will be given below.

### <First Electrode>

As a substrate having an electrode formed thereon, a glass substrate with a width of 560 mm and a length of 925 mm, having a transparent conductive layer made of SnO₂ formed thereon, was used.

### <First Photovoltaic Element Portion>

On the above glass substrate, a first photovoltaic element portion was formed in accordance with embodiment 1 described above, using a multi-chamber type plasma CVD apparatus. Firstly, a first film formation chamber was evacuated to 0.001 Pa, and the substrate temperature of the substrate provided with the above transparent conductive layer as a first electrode was set to not more than 200°C. A mixed gas was introduced into the first film formation chamber, and the pressure inside the first film formation chamber was maintained at 400 Pa by a valve provided to an exhaust system. Next, as the mixed gas to be introduced into the first film formation chamber, a mixed gas containing silane gas, hydrogen gas, and diborane gas was used. In the above mixed gas, the hydrogen gas had a flow rate 10 times that of the silane gas.

After the above mixed gas was introduced and the pressure inside the first film formation chamber was stabilized, an AC power of 13.56 Hz was input to a cathode electrode to generate plasma between the cathode electrode and an anode electrode. A p-type layer was formed by this plasma. Power density per unit area of the cathode electrode was set to 0.05 W/cm².

The above power density was maintained, and power input was stopped when the p-type layer made of amorphous hydrogenated silicon (a-Si:H) had a thickness of 25 nm. Thereafter, the first film formation chamber was evacuated to vacuum.

Next, an i-type layer made of amorphous hydrogenated silicon (a-Si:H) was formed. The i-type layer was formed by a method identical to the method of forming the p-type layer described above, except that a second film formation chamber was used, and that a mixed gas of silane gas and hydrogen gas was used as a mixed gas to be introduced into the film formation chamber. When the i-type layer was formed, the hydrogen gas had a flow rate 10 times that of the silane gas. Power supply was stopped when the i-type layer had a thickness of 250 nm, and the second film formation chamber was evacuated.

Subsequently, an n-type layer made of amorphous hydrogenated silicon (a-Si:H) was formed in a third film formation chamber. The n-type layer was formed by a method identical to the method of forming the p-type layer described above, except that the third film formation chamber was used, and that a mixed gas containing silane gas, hydrogen gas, and phosphine gas was used as a mixed gas to be introduced into the film formation chamber. When the n-type layer was formed, the hydrogen gas in the above mixed gas had a flow rate 10 times that of the silane gas. Power supply was stopped when the n-type layer had a thickness of 25 nm, and thereafter the film formation chamber was evacuated.

Through the steps described above, the first photovoltaic element portion of pin-type including the i-type layer made of amorphous hydrogenated silicon as a photoelectric conversion layer was formed.

### <Intermediate layer>

The substrate having the components up to the first photovoltaic element portion fabricated in accordance with embodiment 1 described above was placed in a DC magnetron sputtering apparatus to form an intermediate layer. Then, the apparatus was evacuated to a pressure of not more than 10⁻⁴ Pa. Next, the substrate was heated such that the substrate had a temperature of 150°C, and thereafter argon gas of 150 sccm and oxygen gas of 3 sccm were supplied into the apparatus. A direct current (DC) power of 11.7 kW was applied from a DC sputtering power source to a target made of Al-doped zinc oxide (ZnO), and sputtering was performed while transporting the substrate. Thus, a transparent intermediate layer made of zinc oxide (ZnO) having a film thickness of about 20 nm (Example 1), 40 nm (Example 2), 50 nm (Example 3), or 70 nm (Example 4) was deposited.

### <Buffer Layer>

A buffer layer made of amorphous silicon was formed over the intermediate layer. The thickness of the buffer layer was set to 3 nm. Formation conditions thereof were identical to those in the method of forming the i-type layer described above, except that H₂ gas had a flow rate about 100 times the flow rate of SiH₄ gas. The crystallization degree represented by Ic/Ia described later was 1.12.

### <Second Photovoltaic Element Portion>

Next, the pin-type photovoltaic element including the i-type layer made of microcrystalline Si:H as the second photovoltaic element portion was fabricated over the buffer layer, using a known film formation apparatus.

In a p-type layer in contact with the buffer layer, the p-type layer of 25 nm was formed under conditions that the flow rate of SiH₄ gas was set to 200 to 400 times the flow rate of hydrogen gas, and film formation pressure was set to 1000 Pa. Under these conditions, the p-type layer having a crystallization degree described later of 23.23 was formed.

An i-type layer and an n-type layer in the second photovoltaic element portion were formed under conditions as in the first photovoltaic element portion. However, as for the i-type layer, a microcrystalline layer of 1.6 µm was formed in accordance with embodiment 1 described above.

### <Second Electrode>

A transparent electrode made of ZnO of 0.1 µm and a metal film made of Ag of 0.2 µm were formed over the second photovoltaic element portion to form a second electrode, and thus the stacked photovoltaic element was manufactured.

The fabricated stacked photovoltaic element was processed by the laser scribing method to have an integrated structure as shown in Figs. 2A and 2B. Specifically, it was processed to have an integrated structure in which cells were integrated in 50 stages. Such an integrated structure is specifically a structure in which stages including the first separation groove 15/the second separation groove 17/the third separation groove 18, and intermediate layer separation groove 16 are integrated.

Conversion efficiency of the obtained stacked photovoltaic element was evaluated under conditions of AM of 1.5, 100 mW/cm², and a temperature of 25°C. Table 1 shows the results.

**[Table 1]**

| | Example 1 | Example 2 | Example 3 | Example 4 |
|---|---|---|---|---|
| Intermediate layer Thickness | 20 nm | 40 nm | 50 nm | 70 nm |
| EFF_{MB}/FF_{M} | 1.32 | 1.15 | 1.24 | 1.27 |
| Film Surface State | No White Turbidity | No White Turbidity | No White Turbidity | No White Turbidity |

In Table 1, EFF_{MB} represents conversion efficiency of a stacked photovoltaic element manufactured in each example, and EFF_{M} represents conversion efficiency of a stacked photovoltaic element provided with an intermediate layer and not including a buffer layer, formed under conditions for each example. In Table 1, conversion efficiency was evaluated based on a value of EFF_{MB} with respect to EFF_{M} (EFF_{MB}/EFF_{M}). It was found that, in any of the examples, the stacked photovoltaic element including an intermediate layer and a buffer layer in the present invention has improved conversion efficiency when compared with the stacked photovoltaic element including only an intermediate layer. Further, film surface state refers to the state of a surface of the obtained stacked photovoltaic element visually observed. When a film surface has a good appearance over the entire substrate, abnormality in the appearance of the film surface cannot be perceived visually.

On the other hand, when the i-type layer has an insufficient crystallization degree, light is scattered and white turbidity is recognized in a portion having an insufficient crystallization degree when compared with a portion having a sufficient crystallization degree, due to a difference in optical characteristics in a deposited film. No white turbidity means that the crystallization degree of the i-type layer indicates that a good microcrystal is deposited over a surface of the substrate.

When the structure of sandwiching the amorphous buffer layer between the intermediate layer made of ZnO and the p-type microcrystalline layer of the second photovoltaic element portion as described above is employed, the amorphous layer is likely to be formed uniformly over the intermediate layer made of ZnO when compared with the microcrystalline layer. Thus, it can be said that influence of hydrogen-containing plasma on the intermediate layer made of ZnO can become more uniform in a direction of the surface of the substrate, when compared with a case where the second photovoltaic element portion is directly provided over the intermediate layer. Further, it was shown that nucleation in the microcrystalline layer is facilitated over the amorphous buffer layer when compared with over the intermediate layer made of ZnO, and a uniform microcrystalline layer can be formed.

### (Examples 5 to 9, Comparative Example 1)

Stacked photovoltaic elements were fabricated as in example 1, except that the thickness of the buffer layer was set variously in a range of 0 nm to 15 nm, and the thickness of the intermediate layer was set to 100 nm. Comparative example 1 is a case where the buffer layer had a thickness of 0 nm, that is, no buffer layer was provided.

Conversion efficiency of each obtained stacked photovoltaic element was evaluated as in example 1. Table 2 shows the results.

**[Table 2]**

| | Comparative Example 1 | Example 5 | Example 6 | Example 7 | Example 8 | Example 9 |
|---|---|---|---|---|---|---|
| Buffer Layer Thickness | 0 nm | 2 nm | 3.7nm | 6.2 nm | 10 nm | 12 nm |
| EFF | 1.0 | 1.23 | 1.28 | 1.28 | 1.29 | 1.14 |

From the results in Table 2, it can be seen that conversion efficiency is improved by providing a buffer layer, as in examples 1 to 4. Further, the results of conversion efficiency were good particularly when the buffer layer had a thickness of not more than 10 nm. This is considered because, when the buffer layer has a film thickness of not more than 10 nm, a layer formed subsequent to the buffer layer is in a microcrystalline condition, and thus the state of adhesion to the surface of the intermediate layer is improved.

It can be said that the range of conductivity of the conductive layer made of an amorphous silicon layer of not less than 5×10⁻³ S/cm and not more than 5×10⁻¹ S/cm is the range in which contact at an interface with ZnO is not deteriorated.

### (Examples 10 to 15)

Concerning the formation conditions for a microcrystalline silicon layer as the conductive layer of the second photovoltaic element portion in contact with the buffer layer, the flow rate of H₂ gas was set to be identical to that in example 1, and the flow rate of H₂ gas was changed in a range of about not less than 10 times and not more than 350 times the flow rate of SiH₄ gas, to change the crystallization degree. Thus, six types of stacked photovoltaic elements were manufactured. Deposition time was adjusted such that the conductive layer had a constant film thickness. The photovoltaic elements were manufactured under conditions identical to those in example 1, except for formation of such a conductive layer.

Regarding the conductive layer corresponding to the obtained photovoltaic element, the crystallization degree was measured using a film deposited by 100 nm over glass under conditions identical to those for forming the conductive layer. The crystallization degree is the ratio of peak height Ic of crystalline silicon of 520 cm⁻¹ attributed to a silicon-silicon bonding to peak height Ia of amorphous silicon of 480 cm⁻¹, in Raman scattering spectrum of a single semiconductor layer, that is, Ic/Ia. Further, conversion efficiency was measured as in example 1. Table 3 shows relationship between the crystallization degree and the conversion efficiency.

**[Table 3]**

| | Example 10 | Example 11 | Example 12 | Example 13 | Example 14 | Example 15 |
|---|---|---|---|---|---|---|
| Crystallization Degree | 1.1 | 3.7 | 7.8 | 10.1 | 15.1 | 23.3 |
| EFF | 0.686 | 0.752 | 0.876 | 0.980 | 0.990 | 1.00 |

The results in Table 3 showed that, in examples 13, 14, and 15 in which the crystallization degree was not less than 10, conversion efficiency (EFF) was improved when compared with a case where the crystallization degree was less than 10.

Although the embodiments and examples of the present invention have been described above, it is also originally intended to combine features of the embodiments and examples described above as appropriate.

It should be understood that the embodiments and examples disclosed herein are illustrative and non-restrictive in every respect. The scope of the present invention is defined by the scope of the claims, rather than the description above, and is intended to include any modifications within the scope and meaning equivalent to the scope of the claims.

### REFERENCE SIGNS LIST

1: substrate, 2: the first electrode, 3: the first photovoltaic element portion, 3a: p-type layer, 3b: i-type layer, 3c: n-type layer, 5: the second photovoltaic element portion, 5a: p-type layer, 5b: i-type layer, 5c: n-type layer, 6: the second electrode, 6a: transparent conductive film, 6b: metal film, 7: intermediate layer, 8: buffer layer, 100: stacked photovoltaic element.

## Claims

1. A stacked photovoltaic element (100), comprising:
a first photovoltaic element portion (3) including at least one photovoltaic element, stacked over a substrate (1);
an intermediate layer (7) made of a metal oxide, stacked over said first photovoltaic element portion (3);
a buffer layer (8) in an amorphous state, stacked over said intermediate layer (7); and
a second photovoltaic element portion (5) including at least one photovoltaic element, stacked over said buffer layer (8),
wherein a conductive layer (5a) of said second photovoltaic element portion (5) in contact with said buffer layer (8) is a microcrystalline layer.

2. The stacked photovoltaic element (100) according to claim 1, wherein said buffer layer (8) and said microcrystalline layer are layers made of silicon-based semiconductors.

3. The stacked photovoltaic element (100) according to claim 1 or 2, wherein said intermediate layer (7) is composed of a substantially undoped metal oxide.

4. The stacked photovoltaic element (100) according to any of claims 1 to 3, wherein said buffer layer (8) has a thickness of not more than 10 nm.

5. The stacked photovoltaic element (100) according to any of claims 1 to 4, wherein said buffer layer (8) has a conductivity of not less than 5×10⁻³ S/cm and not more than 5×10⁻¹ S/cm.

6. The stacked photovoltaic element (100) according to any of claims 1 to 5, wherein said microcrystalline layer is made of a silicon-based semiconductor having a crystallization degree of not less than 10.

7. The stacked photovoltaic element (100) according to any of claims 1 to 6, wherein said intermediate layer (7) is made of a metal oxide having a conductivity of not less than 2×10⁻¹² S/cm and not more than 110⁻⁶ S/cm as a single film.

8. The stacked photovoltaic element (100) according to any of claims 1 to 7, wherein said intermediate layer (7) is made of zinc oxide.

9. The stacked photovoltaic element (100) according to any of claims 1 to 8, wherein the stacked photovoltaic element has an integrated structure.

10. The stacked photovoltaic element (100) according to any of claims 1 to 9, wherein said first photovoltaic element portion (3) has at least a pin-type junction, and an i-type layer (3b) included in the pin-type junction is composed of an amorphous silicon-based semiconductor.

11. The stacked photovoltaic element (100) according to any of claims 1 to 10, wherein said second photovoltaic element portion (5) has at least a pin-type junction, and an i-type layer (5b) included in the pin-type junction is composed of a silicon-based semiconductor containing a crystalline substance.

12. The stacked photovoltaic element (300) according to any of claims 1 to 11, wherein
the stacked photovoltaic element comprises said first photovoltaic element portion (3) and said second photovoltaic element portion (5) in order from a light incident side,
said first photovoltaic element portion (3) includes a first pin structural body (31) and a second pin structural body (32), and
an i-type layer (3b) included in said first pin structural body (31) is composed of amorphous silicon, or amorphous SiC, or amorphous SiO.

13. A method of manufacturing a stacked photovoltaic element, comprising the steps of:
stacking a first photovoltaic element portion (3) including at least one photovoltaic element over a substrate (1);
stacking an intermediate layer (7) made of a metal oxide over the first photovoltaic element portion (3);
stacking a buffer layer (8) in an amorphous state over the intermediate layer (7);
exposing the buffer layer (8) to hydrogen-containing plasma; and
stacking a second photovoltaic element portion (5) including at least one photovoltaic element over the buffer layer (8),
wherein a conductive layer (5a) of said second photovoltaic element portion (5) in contact with said buffer layer (8) is a microcrystalline layer.
